# EUROPÄISCHE PATENTANMELDUNG

(11) **EP 1 136 761 A1**
(43) Veröffentlichungstag der Anmeldung: **26.09.2001**
(21) Anmeldenummer: 01105974.8
(22) Anmeldetag: 10.03.2001
(51) Int. Cl.: F24F 7/10, F24F 5/00, E04F 15/024

(54) **Belüftbare Bodenplatte**

(30) Priorität: 21.03.2000 DE 20005184 U
(71) Anmelder: Viessmann, Hans, Dr., 95030 Hof/Saale (DE)
(72) Erfinder: Viessmann, Hans, Dr., 95030 Hof/Saale (DE)
(74) Vertreter: Wolf, Günter, Dipl.-Ing.

(57) **Zusammenfassung**

Die Erfindung betrifft eine belüftbare Bodenplatte für im Freien aufzustellende Raumzellen, wie sogenannte Mobilfunkcontainer od.dgl., die aus gut wärmeisolierten Wand-und Dekkenelementen gebildet sind. Nach der Erfindung ist in der vorgefertigten und mit dem natürlichen Boden in Wärmeleitkontakt stehenden Bodenplatte (1) mindestens ein im wesentlichen deren Gesamtfläche (F) erfassender Belüftungskanal (2) angeordnet, dessen Zuströmöffnung (3) in der Atmosphäre und dessen Abströmöffnung (4) in der Plattenoberfläche zum Zelleninnenraum hin ausmündet.

## Beschreibung

Die Erfindung betrifft eine belüftbare Bodenplatte zu Kühlzwecken von insbesondere im Freien aufzustellende Raumzellen, wie sogenannte Mobilfunkcontainer od.dgl., die aus auf der Bodenplatte zu errichtenden Wand- und Deckenelementen gebildet sind.

Nachfolgend wird der Einfachheit halber auf Mobilfunkcontainer Bezug genommen, die für Richtfunkzwecke in ausreichender Dichte in der Landschaft verteilt in der Regel auf erhöhtem Gelände aufgestellt werden müssen, um die dafür notwendigen Funkgerätschaften wetter-und temperaturgeschützt unterzubringen zu können. Um in solchen mehr oder weniger gut wärmeisolierten Mobilfunkcontainern für die darin installierten, selbst Wärme entwickelnden und abgebenden Gerätschaften nachteilige Extremtemperaturen auszuschließen, ist es bislang notwendig und wurde auch als notwendig angesehen, derartige Raumzellen mit Klimageräten auszustatten, die jedoch teuer, störanfällig und wartungsbedürftig sind. Dies gilt auch dann, wenn für derartige Container Raumzellen benutzt würden, die wie sogenannte Kühl- und Frischhaltezellen aus sehr gut wärmeisilierenden, vorgefertigten Wandbauelementen erstellt werden.

Der Erfindung liegt die Aufgabe zugrunde, einen Ansatz zu finden, solche aus per se vorgefertigten, gut wärmeisolierten Wand-und Deckenelementen erstellte Container bzw. Raumzellen ohne Klimageräte benutzen zu können und in Verbindung damit ein vorfertigt und direkt installierbares Bauelement solcher Zellen dafür auszunutzen und so auszugestalten, daß damit eine kühlende Belüftung solcher Zellen möglich ist.

Als dafür nutzbar hat sich die per se notwendige Bodenplatte solcher aus gut wärmeisolierten Wand-und Deckenelementen gebildeten Raumzellen erwiesen, die nach der vorliegenden Erfindung derart ausgebildet ist, daß in der vorgefertigten Bodenplatte mindestens ein im wesentlichen deren Gesamtfläche erfassender Belüftungskanal angeordnet ist, dessen Zuströmöffnung in der Atmosphäre und dessen Abströmöffnung in der Plattenoberfläche, d.h., im Innenraum der Raumzelle ausmündet.

Abgesehen davon, daß schon die alten Römer insbesondere in Bädern Fußböden hohl verlegt haben, um solche Räume beheizen zu können, sind hohl verlegte Böden natürlich auch in der Neuzeit bekannt, wozu bspw. auf die DE-A-35 10 475 C1 und die DE-A-22 25 603 verwiesen sei, bei deren Gegenständen es sich um vor Ort zu erstellende Böden besonderer Art handelt, wobei im ersten Fall der zu verlegende Estrich und die dabei einzuhaltenden Randfugen zur Bodenausbildung und dessen Belüftung genutzt werden, und im zweiten Fall handelt es sich um eine ebenfalls vor Ort gewissermaßen nach Römerart zu erstellende Belüftungsanlage zur möglichst gleichmäßig über die ganze Bodenfläche verteilten Luftzuführung.

Bei der erfindungsgemäßen Ausbildung der Bodenplatte in Form einer vorgefertigten Belüftungsplatte für solche Zellen, die ja, von der Raumzelle abgedeckt, immer mehr oder weniger kühl bleibt, wird gewissermaßen deren "Kühlpotential" ausgenutzt, um von außen einströmende Luft, ehe sie in den Innenraum der Zelle gelangt, in der kühlen bzw. relativ kalt bleibenden Belüftungsplatte herunterzukühlen.

Unter "einem im wesentlichen deren Gesamtfläche erfassenden Kühlkanal" ist dabei ein Kanal zu verstehen, der sich vorzugsweise mäandernd mit möglichst großer Länge durch den ganzen Plattenkörper aus Beton bzw. Estrichbeton erstreckt.

Die auf der Bodenplatte stehende Raumzelle ist dabei natürlich im oberen Bereich unter oder in der Zellendecke mit einer Abluftöffnung versehen, durch die per se eine natürliche Entlüftung des Zelleninnenraumes erfolgt, auch wenn ein vorteilhaft und vorzugsweise auf der Abströmöffnung vorgesehens Sauggebläse nicht läuft. Erst wenn diese natürliche Belüftung bei steigender Außentemperatur nicht mehr ausreichen sollte, wird das Sauggebläse per Temperaturreglung eingeschaltet, um eine Zwangsbelüftung durch die kühle bzw. kalte Bodenlatte hindurch zu bewirken, wobei die eingesaugte Luft auf dem relativ langen Weg durch den Belüftungskanal abgekühlt wird.

Da solche erfindungsgemäß belüftbaren Bodenplatten aus Beton bei einer Stärke von ca. 5 bis 10 cm in der Regel eine Größe von ca. 4 m² haben und in Kontakt mit den eigentlichen, entsprechend tief im Boden angelegten Fundamentplatten stehen, besitzen diese eine ausreichende Wärmeaufnahmekapazität, um im Sommer angesaugte Außenluft mit relativ hoher Temperatur auf ein Temperaturniveau in der Raumzelle herunterzukühlen, wie es dort noch als für die dort installierten Gerätschaften zulässig zu fordern ist. Abgesehen vom Wärmeabfluß aus der Platte via Fundamentplatte in den Boden stellt sich die "Kühlkapazität" einer solchen Belüftungsplatte insbesondere nachts immer wieder von selbst her.

Vorteilhafte Weiterbildungen der Belüftungsplatte bestehen in Folgendem:

Vor der zweckmäßig nach Norden orientierten Zuströmöffnung des Belüftungskanales ist ein Schutzelemet, wie Gitter, Filter od.dgl. angeordnet, um Fremdkörper - oder Kleintierzutritt zu unterbinden.

Mit Rücksicht auf einen bequemen Transport ist unter Bezug auf die oben genannte Größenbemessung die Fundamentplatte mindestens zweiteilig ausgebildet, und in jedem Plattenteil ist ein Belüftungskanal angeordnet.

Ferner ist die gebläsebestückte Abströmöffnung des Belüftungskanales im Bereich einer Plattenecke vorgesehen, wodurch die Stellfläche in der Raumzelle vom Gebläse so wenig wie möglich in Anspruch genommen wird.

Schließlich ist die erfindungsgemäß belüftbare Bodenplatte vorteilhaft aus zwei flächig aufeinandergelegten Teilen gebildet, von denen mindestens die eine den gegen ihre Auflagefläche für den anderen Teil offenen Belüftungskanal enthält. Beim bodenseitigen Teil kann es sich dabei um die vor Ort anzulegende Fundamentplatte für die Raumzelle bzw. den Mobilfunkcontainer selbst handeln.

Bevorzugt wird jedoch die Ausführungsform, bei der der bzw. die zur Auflageflächenseite hin offenen Belüftungskanäle eingeformt sind. Zum einen kann dadurch die Bodenplatte dünner als die Fundamentplatte gehalten werden und zum anderen entfällt eine Ausformung der Belüftungskanäle an der Fundamentplatte vor Ort, wobei aber, da die Belüftungskanäle gegen die Fundamentplatte offen sind, die Fundamentplatte selbst auch unmittelbar am Wärmetausch teilnimmt.

Die erfindungsgemäß belüftbare Bodenplatte wird nachfolgend anhand der zeichnerischen Darstellung von Ausführungsbeispielen näher erläutert.

Es zeigt
- Fig. 1: perspektivisch und schematisch die Belüftungsplatte;
- Fig.2: in Draufsicht eine zweiteilige Belüftungsplatte;
- Fig.3,4: im Schnitt Ausführungsformen der Belüftungsplatte und
- Fig.5: im Schnitt die bevorzugte Ausführungsform.

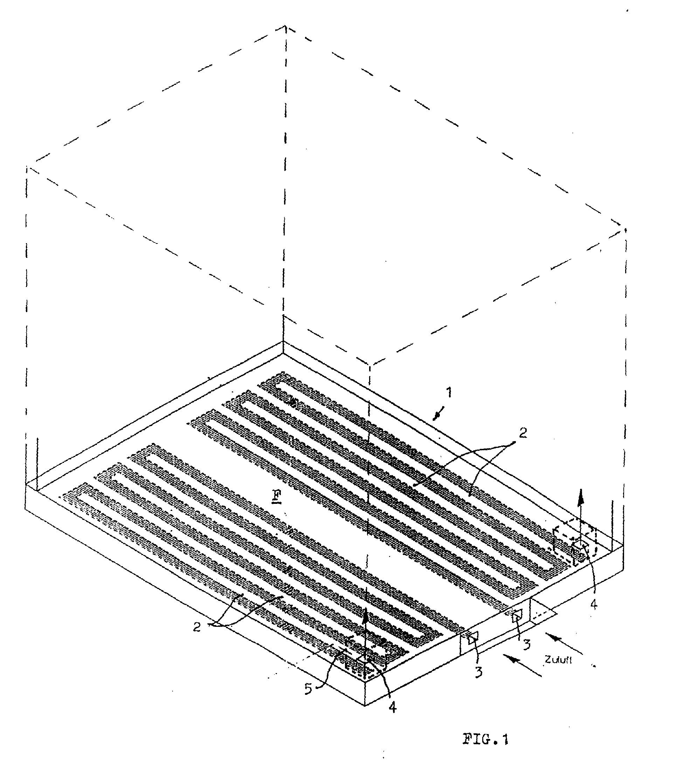

Für die für insbesondere im Freien aufzustellende Raumzellen, wie sogenannte Mobilfunkcontainer od.dgl. vorgefertigte und belüftbare Bodenplatte ist unter Verweis auf Fig.1 wesentlich, daß in der Platte 1 mindestens ein im wesentlichen deren Gesamtfläche F erfassender Belüftungskanal 2 angeordnet ist, dessen Zuströmöffnung 3 in der Atmosphäre und dessen Abströmöffnung 4 in der Plattenoberfläche und damit in der Raumzelle ausmündet.

Um nicht auf einen natürlichen Luftdurchzug via Belüftungskanal 2 in der Raumzelle angewiesen zu sein, d.h., diesbezüglich auch steuernd Einfluß nehmen zu können, ist über der Abströmöffnung 4 ein temperaturgesteuertes Sauggebläse 5 angeordnet. Solche Sauggebläse 5 sind der Einfachheit halber in Fig.1 nur in Form gestrichelter kleiner Kuben angedeutet.

Die Abströmöffnung 4 sind dabei mit den aufgesetzten Gebläsen 5 im Bereich der Plattenecke 7 angeordnet, um die verfügbare Bodenfläche in der Raumzelle so wenig wie möglich in Anspruch zu nehmen.

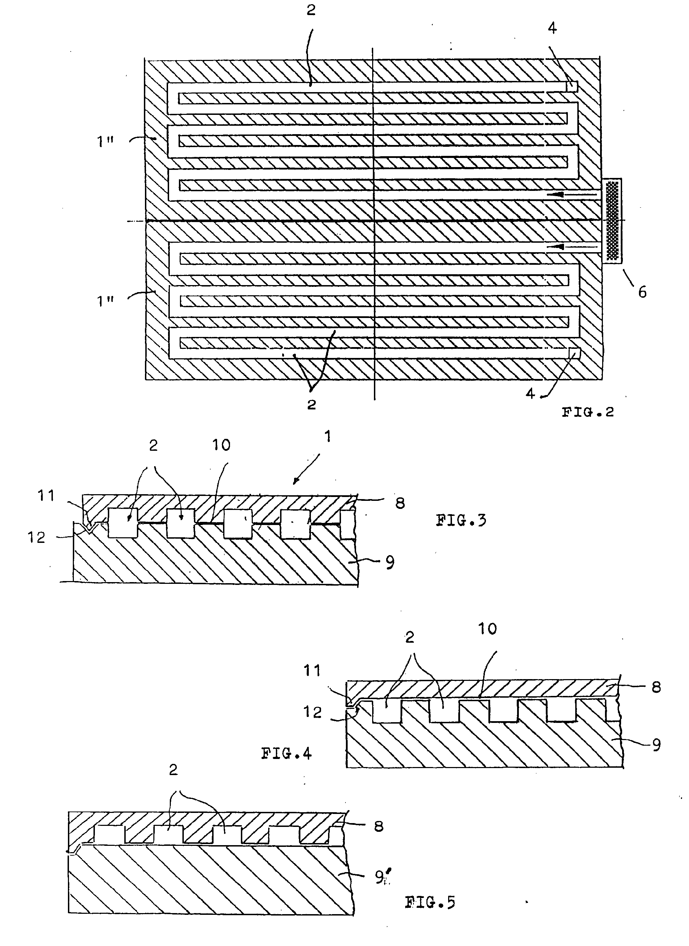

Vor der Zuströmöffnung 3 des Belüftungskanales 2 ist ein Schutzelemet 6 (siehe Fig.2), wie Gitter und/oder Filter od. dgl. angeordnet, um Fremdkörper- bzw. Schmutzzutritt zu unterbinden.

Aus den einleitend genannten Gründen und wie ebenfalls aus Fig.2 ersichtlich, kann die Belüftungsplatte 1 mindestens zweiteilig ausgebildet sein, wobei dann in jedem Plattenteil 1',1" ein Belüftungskanal 2 angeordnet ist, der jeweils in Form, wie bspw. dargestellt, eines engen Mäanders in den Plattenteilen 1',1" verläuft.

Unter Verweis auf die Fig.3,4 ist die Platte 1, egal ob in Draufsicht nun ein- oder mehrteilig aus zwei flächig aufeinandergelegten Teilen 8,9 gebildet, von denen mindestens die eine den gegen ihre Auflagefläche 10 für den anderen Teil 8 oder 9 offenen Belüftungskanal 2 enthält.

Beim Ausführungsbeispiel nach Fig.3 sind dabei in den Teilen 8,9 jeweils nur Hälften des Belüftungskanales 2 eingeformt, während sich beim Ausführungsbeispiel nach Fig.4 der Belüftungskanal nur im stärker bemessenen Teil 9 befindet, wobei dann der Teil 8 praktisch nur eine ebenflächige Deckplatte bildet, die gegf. mit einer einfachen Profilierung 11 versehen ist, mit der sie in eine entsprechende Negativprofilierung 12 des anderen Teiles 9 eingesetzt wird, um die beiden Teile 8,9 gegen Verschiebung zu sichern, was insbesondere auch bei der Ausführungsform nach Fig.3 wichtig ist, damit dort die Hälften der Luftführungskanäle 2 zueinander fluchten.

Diese Ausführungsformen berücksichtigen insbesondere eine möglichst einfache Herstellbarkeit derartiger Bodenplatten, deren Beton lediglich in offene Formen eingefüllt werden muß, deren Boden der Form und dem Verlauf der Belüftungskanäle 2 entsprechenden Profilstegen versehen ist.

Bei diesen Ausführungsbeispielen kann es sich beim bodenseitigen Teil 9 um die vor Ort per se herzustellende Fundamentplatte der betreffenden Raumzelle handeln, wobei jedoch die Ausführungsformen nach den Fig.3,4 den Herstellungsaufwand verlangten, die Fundamentplatte vor Ort mit den Kanälen versehen zu müssen.
Bevorzugt wird deshalb in diesem Zusammenhang und bei zweioteiliger Ausbildung der Bodenplatte die Ausführungsform nach Fig.5, gemäß der die allein mit den nach unten offenen Belüftungskanälen 2 versehene Bodenplatte 1 auf die vor Ort hergestellte und wesentlich dickere Fundamentplatte aufgelegt ist, zumal eine solche für die Ausbildung der belüftbaren Bodenplatte mit herangezogene und im natürlichen Boden eingelassene Fundamentplatte für den vorliegenden Zweck über eine ausreichende und sich über Nacht selbst erneuernde "Kühlkapazität" verfügt, die für den vorliegenden Zweck allein maßgebend ist.

## Patentansprüche

1. Belüftbare Bodenplatte für im Freien aufzustellende Raumzellen, wie sogenannte Mobilfunkcontainer od.dgl., die aus gut wärmeisolierten Wand-und Deckenelementen gebildet sind,
**dadurch gekennzeichnet,**
**daß** in der vorgefertigten und mit dem natürlichen Boden in Wärmeleitkontakt stehenden Bodenplatte (1) mindestens ein im wesentlichen deren Gesamtfläche (F) erfassender Belüftungskanal (2) angeordnet ist, dessen Zuströmöffnung (3) in der Atmosphäre und dessen Abströmöffnung (4) in der Plattenoberfläche zum Zelleninnenraum hin ausmündet.

2. Bodenplatte nach Anspruch 1,
**dadurch gekennzeichnet,**
**daß** über der Abströmöffnung (4) ein Sauggebläse (5) angeordnet ist.

3. Bodenplatte nach Anspruch 1 oder 2,
**dadurch gekennzeichnet,**
**daß** vor der Zuströmöffnung (3) des Belüftungskanales (2) ein Schutzelemet (6), wie Gitter, Filter od.dgl. angeordnet ist.

4. Bodenplatte nach einem der Ansprüche 1 bis 3,
**dadurch gekennzeichnet,**
**daß** die Bodenplatte (1) aus mindestens zwei Teilen gebildet und in jedem Plattenteil (1',1") ein Belüftungskanal (2) angeordnet ist.

5. Bodenplatte nach einem der Ansprüche 1 bis 4,
**dadurch gekennzeichnet,**
**daß** die Abströmöffnung (4) im Bereich einer Plattenecke (7) angeordnet ist.

6. Bodenplatte nach einem der Ansprüche 1 bis 5,
**dadurch gekennzeichnet,**
**daß** der Belüftungskanal (2) in Form eines engen Mäanders in der Belüftungsplatte (1) angeordnet ist.

7. Bodenplatte nach einem der Ansprüche 1 bis 6,
**dadurch gekennzeichnet,**
**daß** die Bodenplatte (1) aus zwei flächig aufeinandergelegten Teilen (8,9) gebildet ist, von denen mindestens die eine den gegen ihre Auflagefläche (10) für den anderen Teil (8 oder 9) offenen Belüftungskanal (2) enthält.

8. Bodenplatte nach Anspruch 7,
**dadurch gekennzeichnet,**
**daß** der eine kanalfreie Teil (9) der Bodenplatte (1) durch eine Zellenfundamentplatte (9') gebildet ist.
